# FASCICULE DE BREVET EUROPEEN

(11) **EP 3 130 933 B1**
(45) Date de publication et mention de la délivrance du brevet: **26.05.2021**
(21) Numéro de dépôt: 16176500.3
(22) Date de dépôt: 27.06.2016
(51) Int. Cl.: G01R 31/317, H04W 24/06

(54) **ÉLÉMENT SÉCURISÉ MÉMORISANT UN PROGRAMME DE TEST, TERMINAL COMPRENANT UN TEL ÉLÉMENT SÉCURISÉ, SYSTÈME ET PROCÉDÉ ASSOCIÉS**
GESICHERTES ELEMENT, DAS EIN TESTPROGRAMM GESPEICHERT HAT, ENDGERÄT, DAS EIN SOLCHES GESICHERTES ELEMENT UMFASST, ENTSPRECHENDES SYSTEM UND ENTSPRECHENDES VERFAHREN
SECURE ELEMENT STORING A TEST PROGRAM, TERMINAL COMPRISING SUCH A SECURE ELEMENT, ASSOCIATED SYSTEM AND METHOD

(30) Priorité: 29.06.2015 FR 1556084
(43) Date de publication de la demande: 15.02.2017
(73) Titulaire: IDEMIA France, 92400 Courbevoie (FR)
(72) Inventeur: FIENAN RAHARDIANTO, Achmad, 92700 COLOMBES (FR); SULISTIYANTO, M., 92700 COLOMBES (FR)
(74) Mandataire: Jacobacci Coralis Harle

(56) Documents cités:
- EP-A1- 2 466 471
- WO-A1-2015/092307
- US-A1- 2004 102 187
- US-A1- 2012 214 473
- US-A1- 2014 013 421

## Description

### DOMAINE TECHNIQUE AUQUEL SE RAPPORTE L'INVENTION

La présente invention concerne le test d'éléments sécurisés destinés à équiper un terminal.

Elle concerne plus particulièrement un élément sécurisé mémorisant un programme de test, un terminal comprenant un tel élément sécurisé, ainsi qu'un système et un procédé associés.

L'invention s'applique particulièrement avantageusement dans le cas où l'on souhaite effectuer des tests d'une application installée dans l'élément sécurisé.

### ARRIERE-PLAN TECHNOLOGIQUE

Lorsqu'une application à exécuter au sein d'un élément sécurisé (par exemple au sein d'une carte à microcircuit) a été développée, il est classique de tester le comportement de l'élément sécurisé (obtenu notamment du fait de l'exécution de l'application développée) dans divers environnements possibles d'utilisation de l'élément sécurisé, notamment dans divers terminaux susceptibles de recevoir cet élément sécurisé.

Des tests de ce type sont toutefois nécessairement limités par les moyens disponibles dans le laboratoire de test concerné : les tests ne peuvent être réalisés qu'avec les terminaux présents dans le laboratoire de test et dans le contexte du (ou des) système(s) de télécommunication disponible(s), ce qui empêche par exemple de tester des fonctionnalités mises en œuvre différemment ou en supplément dans d'autres systèmes de télécommunication (par exemple dans d'autres pays que celui où les tests sont effectués)

EP 2 466 471 A1 (OBERTHUR TECHNOLOGIES, 20 juin 2012) décrit l'utilisation d'un programme de débogage ou de test d'un module matériel de sécurité tel qu'une carte à microprocesseur.

### OBJET DE L'INVENTION

Dans ce contexte, la présente invention propose un élément sécurisé comprenant un processeur, une interface d'entrées-sorties et au moins une mémoire, caractérisé en ce qu'un programme de détection d'informations mémorisé dans la mémoire est conçu pour collecter des informations sur la configuration ou l'environnement de l'élément sécurisé et en ce qu'un programme de test mémorisé dans la mémoire est conçu pour consulter au moins une directive de test reçue à travers l'interface d'entrées-sorties et pour effectuer au moins un test conformément à la directive de test consultée.

Les tests sont ainsi effectués de manière souple, en fonction de directives reçues à travers l'interface d'entrées-sorties, par exemple en provenance d'un serveur distant, ce qui permet en outre de réaliser ces tests dans un contexte éventuellement différent de celui où est situé le laboratoire de test.

Les tests peuvent ainsi être adaptés au mieux à l'élément sécurisé, notamment en fonction des informations collectées, comme expliqué plus loin.

Le programme de détection d'informations et le programme de test peuvent naturellement en pratique être réalisés par un même programme.

Les directives de test sont par exemple réalisées sous la forme de commandes de test ; en variante, il pourrait s'agir de paramètres définissant les tests à effectuer.

On peut d'ailleurs prévoir que l'élément sécurisé reçoive une instruction de lancement de test en provenance du serveur précité, ce qui permet d'effectuer ce test sans intervention de l'utilisateur d'un terminal équipé de l'élément sécurisé.

Selon d'autres caractéristiques optionnelles et donc non-limitatives :
- la directive reçue est mémorisée dans un fichier ;
- le programme de test est conçu pour consulter la directive de test par lecture dans le fichier ;
- le test effectué est un test d'une application mémorisée dans ladite mémoire ;
- le programme de test est conçu pour effectuer le test par envoi de données à l'application, ou par envoi d'au moins une commande à un système d'exploitation de l'élément sécurisé, ou encore par émulation d'au moins une commande reçue d'un terminal via l'interface d'entrées-sorties.

L'invention propose également un terminal équipé d'un élément sécurisé tel que proposé ci-dessus, comprenant au moins un module de communication conçu pour permettre un échange de données avec un serveur tel que le serveur distant précité, par exemple via un réseau local sans fil ou via un réseau de téléphonie mobile.

Le test effectué peut être dans ce cas un test d'un composant (logiciel ou matériel) du terminal.

L'élément sécurisé est par exemple une carte à microcircuit, telle qu'une UICC (pour "*Universal Integrated Circuit Card"*)*.* En variante, l'élément sécurisé peut être un élément sécurisé embarqué (ou eSE pour *"embedded Secure Element"*)*,* par exemple un élément sécurisé soudé au terminal.

L'invention propose aussi un système comprenant un terminal comme il vient d'être évoqué et le serveur précité, dans lequel le serveur est conçu pour recevoir des données générées par l'élément sécurisé, pour déterminer des directives de test en fonction des données générées et pour émettre les directives déterminées à destination de l'élément sécurisé.

Les données générées peuvent comprendre des résultats d'un test préalablement effectué par le programme de test et/ou les informations collectées comme indiqué ci-dessus par le programme de détection d'informations.

Les directives de test peuvent être mémorisées dans une base de données du serveur.

L'invention propose enfin un procédé mis en œuvre du fait de l'exécution d'au moins un programme mémorisé dans une mémoire d'un élément sécurisé comprenant un processeur et une interface d'entrées-sorties, comprenant les étapes suivantes :
- collecte d'informations sur la configuration ou l'environnement de l'élément sécurisé ;
- consultation d'au moins une directive de test reçue à travers l'interface d'entrées-sorties ;
- mise en œuvre d'au moins un test conformément à la directive de test consultée.

### DESCRIPTION DETAILLEE D'UN EXEMPLE DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 représente un exemple de contexte dans lequel peut être mise en œuvre l'invention ;
- la figure 2 représente les interactions entre diverses entités fonctionnelles utilisées dans le cadre de l'invention ;
- la figure 3 représente les étapes principales d'un procédé de test d'une application tel que proposé par l'invention ;
- la figure 4 représente un premier exemple d'échanges mis en œuvre au cours d'un tel procédé de test ;
- la figure 5 représente des échanges mis en œuvre suite à ceux de la figure 4, dans un mode de réalisation ;
- la figure 6 représente un exemple de logique d'enchaînement de tests ; et
- la figure 7 représente des échanges mis en œuvre dans un autre mode de réalisation de l'invention.

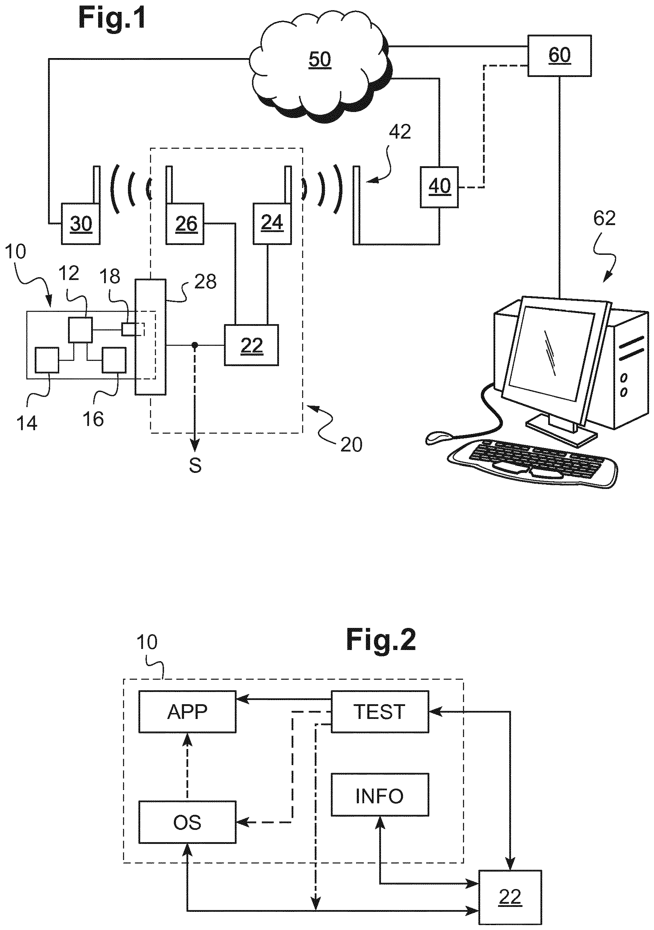

La figure 1 représente un exemple de contexte dans lequel peut être mise en œuvre l'invention.

Un tel contexte comprend notamment un élément sécurisé 10 (ici une carte à microcircuit) et un terminal 20 équipé de ce même élément sécurisé 10.

L'élément sécurisé 10 comprend un processeur 12 (par exemple un microprocesseur), une mémoire non-volatile réinscriptible 14, une mémoire vive 16 et une interface d'entrées-sorties 18.

L'élément sécurisé 10 est conçu, du fait de sa construction physique et de la conception des programmes d'ordinateur qu'elle mémorise, de façon à rendre très difficile, voire impossible, pour un attaquant l'accès (par lecture et/ou modification) aux données confidentielles qu'elle mémorise. Ainsi, l'élément sécurisé 10 a par exemple un niveau d'assurance EAL supérieur à 4 au sens des Critères Communs (norme ISO15408), par exemple une niveau EAL4+ (VAN5) ou supérieur, et/ou un niveau supérieur à 3 selon la norme FIPS 140-2 (pour "*Federal Information Processing Standard").*

L'élément sécurisé 10 est par exemple de type UICC (pour "*Univsersal Intergrated Circuit Card"*)*,* comme défini dans la norme ETSI TS 102 221. Ce type de carte regroupe les cartes de type SIM (pour "*Subscriber Identity Module",* ou de type USIM (pour "*Universal Subscriber Identity Module"),* ainsi que les jetons (ou *"tokens"* selon l'appellation anglo-saxonne) sécurisés, tous identifiables de manière unique.

En variante, l'élément sécurisé peut être un élément sécurisé embarqué (ou intégré, par exemple soudé au terminal 20), ou eSE (pour *"embedded Secure Element*")*,* comme visé notamment dans la spécification "*GlobalPlatform Card Specification Version 2.2.1".* Il s'agit par exemple dans ce cadre d'une carte à circuit intégré universelle et embarquée ou eUICC (pour *"embedded Universal Integrated Circuit Card"*)*,* telle que définie par exemple dans la norme ETSI TS 103 383.

Le terminal 20, par exemple un téléphone cellulaire, comprend un processeur 22 (ici un microcontrôleur qui inclut, outre un microprocesseur, une mémoire non-volatile réinscriptible et une mémoire vive), un premier module de communication 24 conçu pour une connexion à un réseau de téléphonie mobile 40, un second module de communication 26 conçu pour une connexion à un réseau local (ici sans fil) et un lecteur de carte 28 conçu pour coopérer avec l'élément sécurisé 10.

On a représenté sur la figure 1 le processeur 22 du terminal 20 relié séparément au premier module de communication 24, au second module de communication 26 et au lecteur de carte 28. D'autres connexions de ces éléments sont toutefois envisageables, par exemple sur un bus commun.

L'interface d'entrées-sorties 18 comprend ici des contacts respectivement connectés à des plots correspondants du lecteur de carte 28 de sorte que le processeur 22 du terminal 20 et le processeur 12 de l'élément sécurisé 10 peuvent échanger des données, notamment comme expliqué ci-après. En variante, l'interface d'entrées-sorties pourrait être de type sans fil.

Le premier module de communication 24 peut être relié par ondes radio à une station de base avoisinante 42 du réseau de téléphonie mobile 40, ce qui permet au terminal 20 d'utiliser ce réseau de téléphonie mobile 40 pour échanger des données avec d'autres dispositifs électroniques.

En particulier, le réseau de téléphonie mobile 40 est relié à un réseau public 50, tel que le réseau Internet, sur lequel également connecté un serveur de test 60, de sorte que le processeur 22 du terminal 20 peut échanger des données avec le serveur de test 60 via le réseau de téléphonie mobile 40 et le réseau public 50.

On remarque en outre que, selon certains modes de réalisation envisagés dans la suite, le serveur de test 60 peut posséder une connexion directe au réseau de téléphonie mobile 40, ce qui permet un échange de données entre le processeur 22 du terminal 20 et le serveur de test 60 par des moyens propres au réseau de téléphonie mobile, tels qu'un système de messages courts (ou SMS pour *"Short Message System"*)*.*

Le second module de communication 26 permet d'établir un réseau local sans fil (ou WLAN pour *"Wireless Local Area Network"*) avec une passerelle 30 connectée au réseau public 50, de sorte que le processeur 22 du terminal 20 peut également échanger des données avec le serveur de test 60 via la passerelle 30 et le réseau public 50.

Une station de travail 62 est également connectée au serveur de test 60, par exemple via un réseau local (ou LAN pour *"Local Area Network"*)*,* ou, en variante, via un réseau privé virtuel (ou VPN pour *"Virtual Private Network*")*.* La station de travail 62 peut ainsi permettre à un opérateur de configurer certains tests à réaliser comme décrit ci-dessous sous l'impulsion du serveur de test 60.

Comme schématiquement illustré en figure 2, l'élément sécurisé 10 mémorise (par exemple dans la mémoire non-volatile réinscriptible 14) :
- un système d'exploitation OS ;
- une application à tester APP ;
- une application de test TEST ;
- une application de détection d'informations INFO.

Ces éléments sont par exemple chacun réalisés sous forme d'un programme d'ordinateur comprenant des instructions aptes à mettre en œuvre un procédé, notamment tel que décrit ci-dessous, lorsque ces instructions sont exécutées par le microprocesseur 12 de l'élément sécurisé 10.

En variante, au moins un de ces éléments (en particulier l'application à test APP) est formé d'instructions interprétables par une machine virtuelle (non représentée) présente au sein de l'élément sécurisé 10.

L'application de détection d'informations INFO est conçue pour collecter des informations sur la configuration de l'élément sécurisé 10 et sur l'environnement auquel est connecté l'élément sécurisé 10, en particulier des informations relatives au terminal 20 telles que des caractéristiques techniques du terminal 20 et des fonctionnalités disponibles au sein du terminal 20, et pour mémoriser les informations collectées (dans la mémoire non-volatile 14 ou dans la mémoire vive 15) et/ou envoyer les informations collectées à destination du serveur de test 60 (via le terminal 20 et au moyen de l'un des modes d'échange de données entre le terminal 20 et le serveur de test 60 envisagés ci-dessus). On comprend qu'en pratique, ces actions sont mises en œuvre par le processeur 12 lorsque l'application de détection d'informations INFO est exécutée par ce processeur 12.

L'application de test TEST est quant à elle conçue pour lire des commandes de test listées dans un premier fichier dédié mémorisé dans la mémoire non-volatile 14 (ou en variante dans la mémoire vive 16) et pour effectuer des tests de l'application à tester APP conformément aux commandes lues. On comprend qu'en pratique, ces actions sont mises en œuvre par le processeur 12 lorsque l'application de test TEST est exécutée par ce processeur 12.

Comme expliqué ci-après, le premier fichier dédié listant les commandes de test à effectuer est préparé au niveau du serveur de test 60 (éventuellement en fonction notamment d'informations de configuration de test choisies et/ou modifiées au moyen de la station de travail 62) et transmis par celui-ci à l'élément sécurisé 10 (via le terminal 20 et au moyen de l'un des modes d'échange de données entre le terminal 20 et le serveur de test 60 envisagés ci-dessus) afin d'y être stocké dans la mémoire non-volatile 14 (ou en variante dans la mémoire vive 16).

L'application de test TEST est en outre conçue pour écrire les résultats de test dans un second fichier dédié, mémorisé par exemple dans la mémoire non-volatile 14 (ou en variante dans la mémoire vive 16), et/ou pour envoyer les résultats de test au serveur de test (via le terminal 20 et au moyen de l'un des modes d'échange de données entre le terminal 20 et le serveur de test 60 envisagés ci-dessus).

Les applications de détection d'informations INFO et de test TEST peuvent être installées dans l'élément sécurisé 10 lors d'une phase de personnalisation de cet élément sécurisé 10 ou téléchargées (par exemple en provenance du serveur de test 60) au moyen de l'un des modes d'échange envisagés ci-dessus.

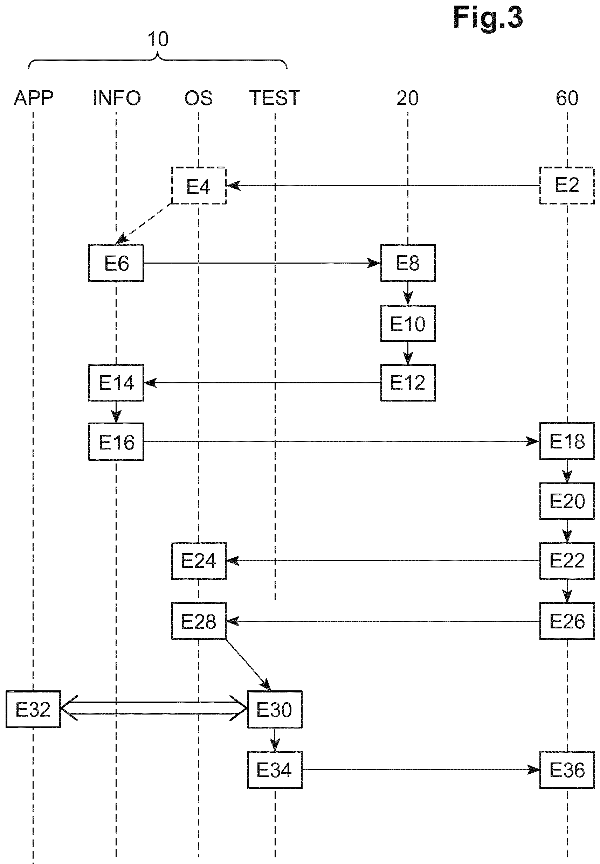

La figure 3 représente les étapes principales d'un procédé de test d'une application tel que proposé par l'invention.

Un tel procédé peut débuter par exemple par l'émission par le serveur de test 60 à l'étape E2 d'une commande d'exécution de l'application de détection d'informations INFO à destination de l'élément sécurisé 10.

On remarque que cette transmission est réalisée via le terminal 20, grâce aux moyens d'échange de données déjà présentés en référence à la figure 1 ; en figure 3, on a toutefois représenté par mesure de simplification cette transmission par une flèche directe entre le serveur de test 60 et le système d'exploitation OS (chargé du lancement de l'application de détection d'informations INFO) puisqu'aucun traitement spécifique (autre que la transmission d'informations) n'est réalisé au niveau du terminal 20 au cours de cette étape.

Cette commande d'exécution de l'application de détection d'informations INFO est reçue par l'élément sécurisé 10 à l'étape E4, ce qui entraîne le lancement par le système d'exploitation OS de l'exécution de l'application de détection d'informations INFO par le processeur 12.

Le lancement de l'exécution de l'application de détection d'informations INFO pourrait également être effectué automatiquement à chaque mise sous tension du terminal 20 (et donc de l'élément sécurisé 10).

L'application de détection d'informations INFO commence son exécution à l'étape E6 en émettant à destination du terminal 20 (précisément de son processeur 22) une demande des caractéristiques et fonctionnalités du terminal 20. Une telle demande est par exemple réalisée en pratique au moyen de commande STK (pour *"SIM ToolKit*") intitulée PROVIDE LOCAL INFORMATION.

Le processeur 22 du terminal 20 reçoit cette demande à l'étape E8 et procède en conséquence à l'étape E10 à la détermination de caractéristiques et de fonctionnalités du terminal 20, par exemple par consultation d'une ou plusieurs zones mémoire dédiées au sein du processeur 22.

Le processeur 22 émet ensuite (étape E12) des données représentatives des caractéristiques et fonctionnalités déterminées à l'étape E10 à destination de l'élément sécurisé 10, précisément du processeur 12 sur lequel s'exécute l'application de détection d'informations INFO.

Ces données représentatives des caractéristiques et fonctionnalités du terminal 20 sont ainsi reçues par l'application de détection d'informations INFO à l'étape E14.

L'application de détection d'informations INFO transmet alors ces données représentatives des caractéristiques et fonctionnalités du terminal 20, ainsi qu'éventuellement des données représentatives de caractéristiques de configuration de l'élément sécurisé 10, à destination du serveur de test 60 (étape E16), ce qui constitue, dans l'exemple décrit ici, la dernière étape de l'exécution de l'application de détection d'informations INFO.

En variante, comme déjà indiqué, l'application de détection d'informations INFO pourrait écrire les données représentatives des caractéristiques et fonctionnalités du terminal 20 dans la mémoire non-volatile 14, dans une région de cette mémoire consultable par le serveur de test 60.

Le serveur de test 60 reçoit à l'étape E18 les données représentatives des caractéristiques et fonctionnalités du terminal 20, et éventuellement les données représentatives de caractéristiques de configuration de l'élément sécurisé 10 (ou lit ces données dans la mémoire non-volatile 14 dans la variante qui vient d'être mentionnée).

Le serveur de test 60 prépare alors à l'étape E20 un ensemble de commandes (ou directives) de test en tenant compte des données représentatives des caractéristiques et fonctionnalités du terminal 20 et, le cas échéant, des données représentatives de caractéristiques de configuration de l'élément sécurisé 10. Cet ensemble de commandes de test (ou directives de test) définit un protocole de test que l'on souhaite appliquer à l'application APP et qui est adapté en fonction de la configuration de l'élément sécurisé 10, des caractéristiques du terminal 20 et des fonctionnalités offertes par ce terminal 20. Ainsi, les commandes de test faisant partie de l'ensemble, ainsi que les paramètres de chacune de ces commandes, sont choisis en fonction des données représentatives des caractéristiques et fonctionnalités du terminal 20 (et éventuellement des données représentatives de caractéristiques de configuration de l'élément sécurisé 10) reçues à l'étape E18.

Le serveur de test 60 émet alors à l'étape E22 une commande d'écriture (destinée au système d'exploitation OS), dans la mémoire non-volatile 14 (ou en variante dans la mémoire vive 16), de l'ensemble de commandes préparé à l'étape E20. Comme indiqué ci-dessus, ces commandes sont par exemple écrites au sein du premier fichier dédié mémorisé dans la mémoire non-volatile 14.

Le système d'exploitation OS de l'élément sécurisé 10 (exécuté par le processeur 12) écrit par conséquent l'ensemble de commandes dans la mémoire non-volatile 14 à l'étape E22.

Le serveur de test émet ensuite à l'étape E26 une commande d'exécution de l'application de test TEST à destination de l'élément sécurisé 10.

Cette commande d'exécution de l'application de test TEST est reçue par l'élément sécurisé 10 à l'étape E28, ce qui entraîne le lancement par le système d'exploitation OS de l'exécution de l'application de test TEST par le processeur 12.

L'application de test TEST s'exécute donc à l'étape E30, en lisant les commandes de test listées dans le premier fichier dédié mémorisé dans la mémoire non-volatile 14 et en effectuant, pour chaque commande lue, un test correspondant de l'application à tester APP, ce qui provoque, pour chaque test, une exécution partielle de cette application APP (c'est-à-dire une exécution de certaines instructions de l'application APP, étape E32) et un échange de données entre l'application de test TEST et l'application à tester APP. Les commandes de test sont par exemple des commandes définies dans des spécifications techniques, éventuellement des commandes normalisées. Il peut s'agir par exemple d'une commande STORE DATA prévue dans la spécification GlobalPlatform, avec laquelle des paramètres peuvent être modifiés. On remarque que les réponses à une commande de test peuvent provenir directement de l'application à tester APP et/ou du système d'exploitation OS.

Selon un premier mode de réalisation envisageable, l'application de test TEST teste directement l'application à tester APP, comme indiqué schématiquement par une flèche en trait plein en figure 2, par exemple par envoi d'une série de commandes à l'application APP. Dans ce cas, l'application TEST envoie par exemple des commandes directement à l'application APP via ses interfaces de programmation (ou API pour *"Application Programming Interface"*) et reçoit alors les réponses soit directement de l'application APP, soit via le système d'exploitation OS. Ces commandes peuvent tester l'ensemble de l'application ou seulement certains composants (i.e. parties) de l'application.

Selon un second mode de réalisation, l'application de TEST effectue des tests de l'application à tester APP en envoyant des commandes dans ce but au système d'exploitation OS de l'élément sécurisé 10, comme représenté schématiquement par une flèche en pointillés en figure 2.

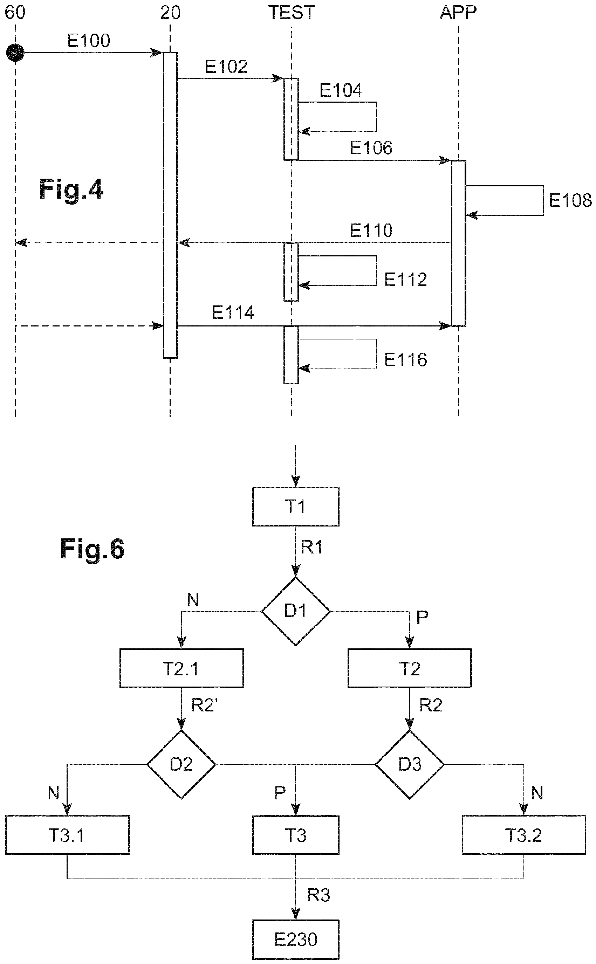

Selon un troisième mode de réalisation, l'application de TEST émule des commandes générées par le terminal 20 (précisément par le processeur 22 du terminal 20) : ces commandes de test sont transmises via la liaison prévue entre l'élément sécurisé 10 et le terminal 20, comme schématiquement représenté en traits mixtes en figure 2. Un exemple d'utilisation de ce mode de réalisation est décrit ci-dessous en référence à la figure 4.

Au cours de l'étape E30, l'application de test TEST écrit en outre dans le second fichier dédié les résultats de test, au fur et à mesure des tests mis en œuvre conformément aux commandes lues dans le premier fichier dédié.

Il est également envisageable au cours des tests de surveiller les données échangées entre l'élément sécurisé 10 et le terminal 20 en connectant par exemple un ordinateur personnel sur une sortie dédiée S (schématiquement représentée en figure 1) située sur la liaison élément sécurisé 10 - terminal 20.

Une fois tous les tests (correspondant à l'ensemble des commandes listées dans le premier fichier dédié) effectués, l'application de test TEST transmet à l'étape E34 les résultats de test (mémorisés comme indiqué ci-dessus dans le second fichier dédié) à destination du serveur de test 60, ce qui constitue, dans l'exemple décrit ici, la dernière étape de l'exécution de l'application de test TEST.

Le serveur de test 60 reçoit à l'étape E36 les résultats de test et peut ainsi procéder à leur traitement et à leur analyse. En variante, le serveur de test 60 ne reçoit pas les résultats de test en provenance de l'application de test TEST, mais lit ces résultats dans la mémoire non-volatile 14 (précisément dans le second fichier dédié).

La figure 4 représente un premier exemple d'échanges mis en œuvre au cours d'un procédé de test tel que celui qui vient d'être décrit.

Ces échanges débutent à l'étape E100 par l'émission par le serveur de test 60 d'une commande de déclenchement des tests, par exemple comme indiqué ci-dessus une commande d'exécution de l'application de test TEST. En pratique, cette commande est reçue par le terminal 20 et transmise par celui-ci à l'élément sécurisé 10 (étape E102), ce qui provoque le lancement de l'application de test TEST.

On remarque que les étapes E100 et E102 correspondent à l'étape E26 de la figure 3.

L'application de test TEST lit alors une commande de test dans le premier fichier dédié et vérifie le format de cette commande. L'application de test TEST écrit par ailleurs (par exemple dans le second fichier dédié mentionné plus haut) un évènement de début de test (étape E104).

L'application de test TEST émet ensuite à l'étape E106 un message de test (correspondant à la commande de test lue dans le premier fichier dédié) à destination de l'application à tester APP. Il s'agit ici d'un message émulant un message généré par le terminal 20 (par exemple un message de type SMSPP).

L'application à tester APP reçoit ce message et effectue un traitement prévu en conséquence (étape E108). Ce traitement se termine ici par l'émission à l'étape E110 d'un message en réponse, envoyé ici sur le réseau de téléphonie mobile 40 au moyen du terminal 20. Ce message en réponse est par exemple de type SMS et peut être adressé au serveur de test 60.

L'application de test TEST constate l'émission de ce message en réponse (par exemple par observation des données échangées entre l'élément sécurisé 10 et le terminal 20) et mémorise un évènement correspondant dans le second fichier dédié (étape E112).

L'application à tester APP reçoit ensuite une réponse du terminal, ou en variante du serveur, à l'étape E114. Une telle réponse est par exemple un accusé de réception du message émis à l'étape E110. En variante, par l'émission du message à l'étape E110, l'application APP peut demander la mise en œuvre d'une action au niveau du terminal 20, par exemple une action de l'utilisateur telle que la lecture d'une empreinte digitale de l'utilisateur au moyen du terminal 20, comme prévu par exemple dans la spécification FIDO U2F ou FIDO UAF.

L'application de test TEST constate la réception de cette réponse et mémorise un événement correspondant dans le second fichier dédié (étape E116).

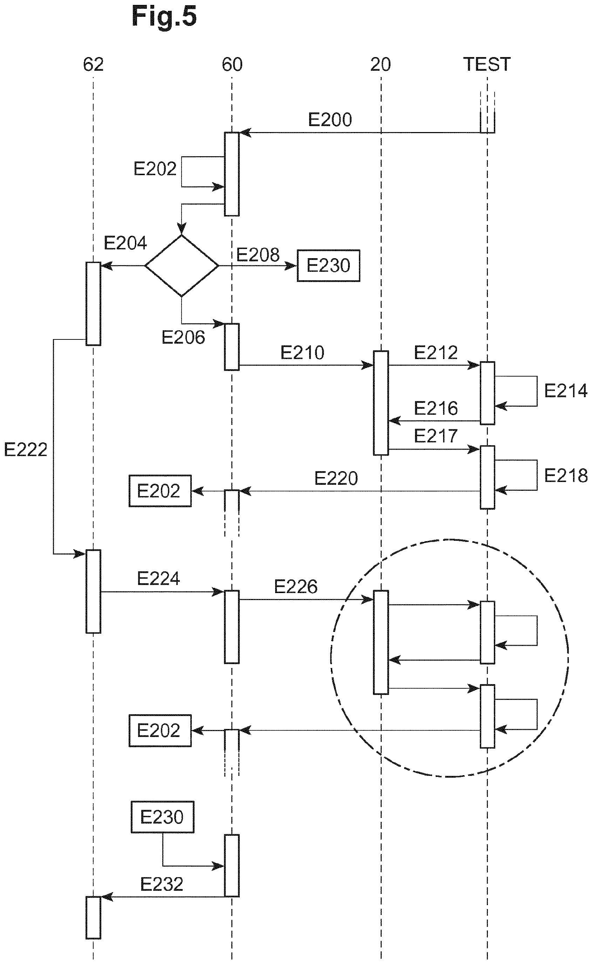

Les tests peuvent alors se poursuivre, comme décrit ci-dessous en référence à la figure 5, ou s'achever, comme décrit ci-dessus à l'étape E34 de l'exemple présenté en figure 3.

La figure 5 représente des échanges mis en œuvre suite à ceux de la figure 4, dans un mode de réalisation.

Ces échanges commencent par l'envoi, à l'étape E200, du second fichier dédié (fichier de résultat listant les évènements mentionnés lors de la description de la figure 4) de l'élément sécurisé 10 (sous la commande de l'application de test TEST) au serveur de test 60. En variante, le serveur de test 60 peut recevoir de l'élément sécurisé 10 une simple indication que les résultats sont disponibles et lire le second fichier dédié dans l'élément sécurisé 10, comme expliqué plus haut.

Le serveur de test 60 peut alors analyser les résultats reçus (contenus dans le second fichier dédiés) à l'étape E202, notamment en les comparant à des résultats-types mémorisés dans une base de données associée au serveur de test 60.

En fonction de l'analyse effectuée à l'étape E202, le serveur de test 60 détermine le traitement ultérieur à effectuer :
- si les résultats reçus ne permettent pas de déterminer automatiquement le traitement ultérieur à effectuer (étape E204), par exemple du fait que les résultats reçus ne correspondent pas à des résultats-types (comportement type) mémorisés dans la base de données, on procède à l'étape E222 décrite ci-dessous ;
- si les résultats reçus permettent de déterminer automatiquement un ensemble ultérieur de tests à effectuer (étape E206), on procède à l'étape E210 décrite plus bas ;
- si les résultats reçus correspondent aux derniers tests à effectuer (étape E208), on procède à l'étape E230 décrite plus bas.

Lorsqu'un nouvel ensemble de tests à effectuer a pu être déterminé automatiquement (étape E206), le serveur de test 60 émet à l'étape E210 un ordre de lancement (ou déclenchement) de ce nouvel ensemble de tests, à destination de l'élément sécurisé 10 via le terminal 20. Le terminal 20 transmet donc cet ordre à l'élément sécurisé 10 à l'étape E212.

En pratique, cet ordre de lancement peut comprendre d'une part l'écriture des commandes de test du nouvel ensemble dans le premier fichier dédié (mémorisé comme déjà indiqué dans la mémoire non-volatile 14 de l'élément sécurisé 10) et une commande d'exécution de l'application de test TEST.

L'application de test TEST lit alors une commande de test dans le premier fichier dédié et vérifie le format de cette commande. L'application de test TEST écrit par ailleurs (par exemple dans le second fichier dédié mentionné plus haut) un évènement de début de test (étape E214).

L'application de test TEST exécute ensuite la commande de test lue (étape E216), qui implique ici l'émission d'une commande à destination du terminal 20 afin par exemple de tester une application du terminal 20.

L'application de test TEST reçoit un message en réponse (étape E217) et mémorise un évènement correspondant dans le second fichier dédié (étape E218).

Les étapes E216 à E218 peuvent ainsi être réitérées pour chacune des commandes de l'ensemble de tests à effectuer (commandes listées dans le premier fichier dédié).

L'élément sécurisé 10 (du fait de l'exécution de l'application de test TEST) envoie alors, à l'étape E220, le second fichier dédié (fichier de résultat listant les évènements enregistrés au cours des étapes E214 et E218) au serveur de test 60 (ou en variante, une simple indication que les résultats sont disponibles, auquel cas le serveur de test 60 pourra lire le second fichier dédié).

Le procédé se poursuit alors comme déjà expliqué ci-dessus à l'étape E202.

Lorsque le traitement ultérieur ne peut pas être déterminé automatiquement sur la base des résultats de test reçus (étape E204 décrite ci-dessus), cette information est communiquée à un opérateur (par exemple au niveau de la station de travail 62), de sorte que l'opérateur puisse définir un nouvel ensemble de tests (étape E222) par interaction avec la station de travail 62.

Une fois complètement défini, le nouvel ensemble de tests ainsi déterminé est transmis de la station de travail 62 au serveur de test 60 (étape E224).

Un ordre de lancement de ce nouvel ensemble de tests est alors émis (étape E226) par le serveur de test 60 et ces tests sont effectués conformément à un processus du même type que celui décrit ci-dessus aux étapes E212 à E220 et qui ne sera donc pas décrit à nouveau.

Lorsque les tests sont terminés, le serveur de test 60 prépare un document de conclusion récapitulant tous les tests effectués (étape E230) et affiche ce document de conclusion au niveau de la station de travail 62 afin que l'opérateur puisse en prendre connaissance.

La figure 6 représente un exemple de logique d'enchaînement de tests.

Dans cet exemple, on procède tout d'abord à un premier ensemble de tests T1, par exemple conformément à ce qui a été décrit ci-dessus en référence à la figure 4.

Le serveur de test 60 reçoit alors les résultats R1 du premier ensemble de tests T1. Ces résultats R1 sont représentatifs d'un comportement du système testé, ici l'application APP.

Le serveur de test 60 détermine alors à l'étape D1 si ces résultats R1 correspondent à un comportement répertorié dans la base de données associée au serveur de test 60.

Dans l'affirmative (flèche P), le serveur de test 60 lance un second ensemble de tests T2 préalablement mémorisé au sein de la base de données en correspondance avec le comportement répertorié correspondant aux résultats R1. Ce second ensemble de tests T2 est mis en œuvre, par exemple conformément aux étapes E210 à E220 décrites ci-dessus en référence à la figure 5 et produit un résultat R2 (utilisé comme décrit plus loin).

Dans la négative (flèche N), un nouvel ensemble de tests T2.1 est créé puis lancé, par exemple conformément à ce qui a été décrit ci-dessus en référence aux étapes E222 à E226. Cet ensemble de tests T2.1 est mis en œuvre au niveau de l'élément sécurisé 10 et produit un résultat R2'.

Le serveur de test 60 détermine alors à l'étape D2 si ces résultats R2' correspondent à un comportement répertorié dans la base de données associée au serveur de test 60.

Dans l'affirmative (flèche P), le serveur de test 60 lance un troisième ensemble de tests T3 préalablement mémorisé au sein de la base de données en correspondance avec le comportement répertorié correspondant aux résultats R2'. Ce troisième ensemble de tests T3 est mis en œuvre par l'élément sécurisé 10.

Dans la négative (flèche N), un nouvel ensemble de tests T3.1 est créé puis lancé par le serveur de test 60 en vue de sa mise en œuvre au niveau de l'élément sécurisé 10.

En revenant au cas où des résultats R2 sont produits, le serveur de test 60 détermine à l'étape D3 si ces résultats R2 correspondent à un comportement répertorié dans la base de données associée au serveur de test 60.

Dans l'affirmative (flèche P), le serveur de test 60 lance un ensemble de tests préalablement mémorisé au sein de la base de données en correspondance avec le comportement répertorié correspondant aux résultats R2, ensemble qui correspond ici au troisième ensemble de tests T3 déjà mentionné. Cet ensemble de tests T3 est mis en œuvre par l'élément sécurisé 10.

Dans la négative (flèche N), un nouvel ensemble de tests T3.2 est créé puis lancé par le serveur de test 60 en vue de sa mise en œuvre au niveau de l'élément sécurisé 10.

Quel que soit l'ensemble de test mis en œuvre (parmi ceux référencés ci-dessus T3, T3.1 et T3.2), cet ensemble de test produit un résultat noté ici R3 qui est transmis de l'élément sécurisé 10 au serveur de test 60 (ou lu par le serveur de test 60 dans l'élément sécurisé 10 comme indiqué plus haut).

Le serveur de test 60 génère alors le document de conclusion sur la base des résultats reçus R1, R3, R2 ou R2', comme expliqué ci-dessus (étape E230).

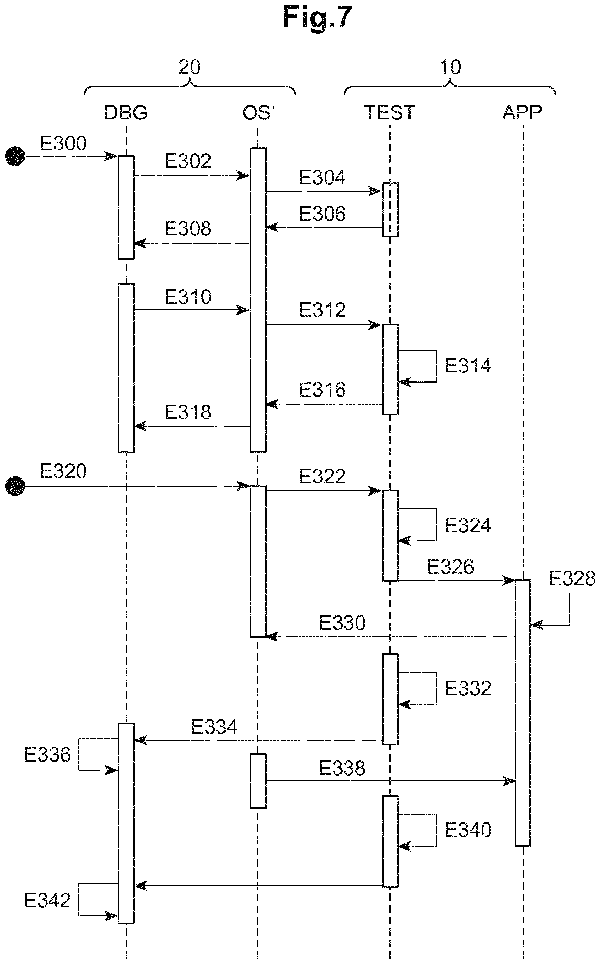

La figure 7 représente des échanges mis en œuvre dans un autre mode de réalisation de l'invention.

Dans ce mode de réalisation, une application de suivi de test DBG (par exemple une application compagnon ou *"wallet app"*) est installée dans le terminal 20 et exécutable par le processeur 22. Comme expliqué ci-dessous, cette application DBG permet d'initier et de gérer un mode de suivi du déroulement des tests sur un écran (non-représenté) du terminal 20.

Le procédé de la figure 7 débute à l'étape E300 par une demande d'activation du mode de suivi des tests, par exemple du fait du lancement par l'utilisateur de l'application de suivi de test DBG.

L'application de suivi de test DBG émet alors à l'étape E302 une requête de connexion à l'interface d'entrées-sorties 18 afin de pouvoir échanger des données avec l'application de test TEST.

Cette requête est alors traitée par le système d'exploitation OS' du terminal 20, qui met en œuvre la connexion via l'interface d'entrées-sorties 18 et transmet la requête de connexion à l'application de test TEST (étape E304).

L'application de TEST émet une réponse via l'interface d'entrées-sorties 18 à l'étape E306 afin de confirmer que la connexion est établie, réponse qui est transmise à l'application de suivi de test DBG par le système d'exploitation OS' du terminal 20 à l'étape E308.

L'application de suivi de test DBG émet alors à l'étape E310 une commande d'activation du suivi des tests destinée à l'application de test TEST. Cette commande est transmise par l'intermédiaire du système d'exploitation OS' du terminal 20 et via l'interface d'entrées-sorties 18 (étape E312).

L'application de test TEST prend en compte cette commande d'activation à l'étape E314, par exemple en mémorisant dans la mémoire non-volatile 14 un indicateur d'activation du mode de suivi des tests.

L'application de test TEST émet par ailleurs une confirmation de l'activation du mode de suivi des tests (étape E316), confirmation transmise à l'application de suivi de test DBG via l'interface d'entrées-sorties 18 et le système d'exploitation OS' du terminal 20 (étape E318).

À un moment ultérieur, les tests sont déclenchés, par exemple, comme décrit ci-dessus, par l'émission par le serveur de test 60 d'une commande d'exécution de l'application de test TEST (étape E320). En pratique, cette commande est reçue par le système d'exploitation OS' du terminal 20 et transmise par celui-ci à l'élément sécurisé 10 (étape E322) pour lancement de l'application de test TEST.

L'application de test TEST lit alors une commande de test dans le premier fichier dédié et vérifie le format de cette commande. L'application de test TEST écrit par ailleurs (par exemple, comme dans le mode de réalisation de la figure 4, dans le second fichier dédié) un évènement de début de test (étape E324).

Comme déjà décrit en référence à la figure 4, l'application de test TEST émet alors à l'étape E326 un message de test (correspondant à la commande de test lue dans le premier fichier dédié) à destination de l'application à tester APP. Il s'agit par exemple ici aussi d'un message émulant un message généré par le terminal 20 (par exemple un message de type SMSPP).

L'application à tester APP reçoit ce message et effectue un traitement prévu en conséquence (étape E328). Ce traitement se termine par l'émission d'un message en réponse sur le réseau de téléphonie mobile 40 au moyen du terminal 20 : pour ce faire, l'application à tester APP transmet tout d'abord ce message au système d'exploitation OS' du terminal 20 (étape E330). Ce message en réponse est par exemple de type SMS et peut être adressé au serveur de test 60.

L'application de test TEST mémorise un évènement correspondant à cette émission dans le second fichier dédié (étape E332).

L'application de test TEST consulte également la mémoire non-volatile 14 afin de déterminer si un indicateur d'activation du mode de suivi des tests y a été préalablement mémorisé et, dans l'affirmative (comme c'est le cas ici suite à l'étape E314 décrite ci-dessus), d'émettre à destination de l'application de suivi de test DBG des données représentatives de l'événement d'émission précité (étape E334).

Ces données représentatives de l'événement d'émission sont reçues par l'application DBG, qui provoque alors l'affichage de ces données sur l'écran du terminal 20 (étape E336).

L'application à tester APP reçoit ensuite une réponse via le terminal 20 à l'étape E338. L'application de test TEST constate la réception de cette réponse et mémorise un évènement de réception correspondant dans le second fichier dédié à l'étape E340.

L'application de test TEST consulte également la mémoire non-volatile 14 afin de déterminer si un indicateur d'activation du mode de suivi des tests y a été préalablement mémorisé et, dans l'affirmative (comme c'est le cas ici suite à l'étape E314 décrite ci-dessus), d'émettre à destination de l'application de suivi de test DBG des données représentatives de l'événement de réception précité (étape E340).

Ces données représentatives de l'événement d'émission sont reçues par l'application DBG, qui provoque alors l'affichage de ces données sur l'écran du terminal 20 (étape E342).

## Revendications

1. Système comprenant un serveur et un élément sécurisé (10) comprenant un processeur (12), une interface d'entrées-sorties (18) et au moins une mémoire (14), dans lequel un programme de détection d'informations (INFO) mémorisé dans la mémoire (14) est conçu pour collecter des informations sur la configuration ou l'environnement de l'élément sécurisé (10), le serveur étant conçu pour recevoir les informations collectées,
**caractérisé en ce que** le serveur est conçu pour déterminer des directives de test en fonction des informations collectées et pour émettre les directives de test déterminées à destination de l'élément sécurisé, et **en ce qu'**un programme de test (TEST) mémorisé dans la mémoire (14) est conçu pour consulter (E30 ; E104 ; E214 ; E324) au moins une directive de test reçue à travers l'interface d'entrées-sorties (18) et pour effectuer (E32 ; E106 ; E216 ; E326) au moins un test conformément à la directive de test consultée.

2. Système selon la revendication 1, conçu pour recevoir une instruction de lancement de test (E26 ; E100 ; E226 ; E320) en provenance d'un serveur (60).

3. Système selon la revendication 1 ou 2, dans lequel la directive reçue est mémorisée dans un fichier et dans laquelle le programme de test (TEST) est conçu pour consulter la directive de test par lecture dans le fichier.

4. Système selon l'une des revendications 1 à 3, dans lequel le test effectué est un test d'une application (APP) mémorisée dans ladite mémoire (14).

5. Système selon la revendication 4, dans lequel le programme de test (TEST) est conçu pour effectuer le test par envoi de données à l'application (APP).

6. Système selon l'une des revendications 1 à 4, dans lequel le programme de test (TEST) est conçu pour effectuer le test par envoi d'au moins une commande à un système d'exploitation (OS) de l'élément sécurisé (10).

7. Système selon l'une des revendications 1 à 4, dans lequel le programme de test (TEST) est conçu pour effectuer le test par émulation d'au moins une commande reçue d'un terminal (20) via l'interface d'entrées-sorties (18).

8. Système selon l'une des revendications 1 à 7, dans lequel l'élément sécurisé est une carte à microcircuit.

9. Système selon l'une des revendications 1 à 8, comprenant un terminal (20) équipé de l'élément sécurisé (10) et comprenant au moins un module de communication (24 ; 26) conçu pour permettre un échange de données avec le serveur (60).

10. Système selon la revendication 9, dans lequel le module de communication (26) est conçu pour permettre un échange de données avec le serveur (60) via un réseau local sans fil.

11. Système selon la revendication 9, dans lequel le module de communication (24) est conçu pour permettre un échange de données avec le serveur (60) via un réseau de téléphonie mobile (40).

12. Système selon l'une des revendications 9 à 11, dans lequel l'élément sécurisé est soudé au terminal.

13. Système selon l'une des revendications 9 à 12, prise dans la dépendance de l'une des revendications 1 à 3 et dans lequel le test effectué est un test d'un composant du terminal.

14. Système selon l'une des revendications 1 à 13, dans lequel le serveur (60) est conçu pour recevoir (E18 ; E36) des résultats d'un test préalablement effectué par le programme de test (10) et pour déterminer (E20 ; E206 ; E222) les directives de test en fonction desdits résultats

15. Système selon l'une des revendications 14 à 16, dans lequel les directives de test sont mémorisées dans une base de données du serveur (60).

16. Procédé mis en œuvre d'au moins un programme mémorisé dans une mémoire (14) d'un élément sécurisé (10) comprenant un processeur (12) et une interface d'entrées-sorties (18), le au moins un programme comprenant des instructions qui conduisent le système selon l'une des revendications 1-15 à exécuter les étapes suivantes :
- collecte (E14) d'informations sur la configuration ou l 'environnement de l'élément sécurisé (10);
- réception (E18) des informations collectées par un serveur, pour déterminer des directives de test en fonction des informations collectées et pour émettre les directives de test déterminées à destination de l'élément sécurisé;
- consultation (E30 ; E104 ; E214 ; E324) d'au moins une directive de test reçue à travers l'interface d'entrées-sorties (18) ;
- mise en œuvre (E32 ; E106 ; E216 ; E326) d'au moins un test conformément à la directive de test consultée.

## Patentansprüche

1. System mit einem Server und einem gesicherten Element (10), das einen Prozessor (12), eine Eingangs-/Ausgangsschnittstelle (18) und wenigstens einen Speicher (14) aufweist, wobei ein in dem Speicher (14) gespeichertes Informationserkennungsprogramm (INFO) dazu ausgelegt ist, Informationen über den Aufbau oder die Umgebung des gesicherten Elements (10) zu sammeln, wobei der Server dazu ausgelegt ist, die gesammelten Informationen zu empfangen, **dadurch gekennzeichnet, daß** der Server dazu ausgelegt ist, Testvorschriften in Abhängigkeit von den gesammelten Informationen zu bestimmen und die bestimmten Testvorschriften an das gesicherte Element (10) zu schicken, und daß ein im Speicher (14) gespeichertes Testprogramm (TEST) dazu ausgelegt ist, wenigstens eine über die Eingangs-/Ausgangsschnittstelle (18) erhaltene Testvorschrift durchzugehen (E30; E104; E214; E324) und wenigstens einen Test gemäß der durchgegangenen Testvorschrift durchzuführen (E32; E106; E216; E326).

2. System gemäß Anspruch 1, das dazu ausgelegt ist, von einem Server (60) eine Anweisung zum Starten eines Tests (E26; E100; E226; E320) zu erhalten.

3. System gemäß Anspruch 1 oder 2, bei dem die empfangene Vorschrift in einer Datei abgelegt wird und bei dem das Testprogramm (TEST) dazu ausgelegt ist, die Testvorschrift durch Lesen in der Datei durchzugehen.

4. System gemäß einem der Ansprüche 1 bis 3, bei dem der durchgeführte Test ein Test einer im Speicher (14) gespeicherten Anwendung (APP) ist.

5. System gemäß Anspruch 4, bei dem das Testprogramm (TEST) dazu ausgelegt ist, den Test durch Senden von Daten an die Anwendung (APP) durchzuführen.

6. System gemäß einem der Ansprüche 1 bis 4, bei dem das Testprogramm (TEST) dazu ausgelegt ist, den Test durch Senden wenigstens eines Befehls an ein Betriebssystem (OS) des gesicherten Elements (10) durchzuführen.

7. System gemäß einem der Ansprüche 1 bis 4, bei dem das Testprogramm (TEST) dazu ausgelegt ist, den Test durch Emulation wenigstens eines von einem Endgerät (20) über die Eingangs-/Ausgangsschnittstelle (18) erhaltenen Befehls durchzuführen.

8. System gemäß einem der Ansprüche 1 bis 7, bei dem das gesicherte Element eine Mikrochipkarte ist.

9. System gemäß einem der Ansprüche 1 bis 8, das ein mit dem gesicherten Element (10) ausgestattetes Endgerät (20) aufweist und wenigstens ein Kommunikationsmodul (24; 26) aufweist, das dazu ausgelegt ist, einen Datenaustausch mit dem Server (60) zu ermöglichen.

10. System gemäß Anspruch 9, bei dem das Kommunikationsmodul (26) dazu ausgelegt ist, einen Datenaustausch mit dem Server (60) über ein drahtloses örtliches Netz zu ermöglichen.

11. System gemäß Anspruch 9, bei dem das Kommunikationsmodul (24) dazu ausgelegt ist, einen Datenaustausch mit dem Server (60) über ein Mobiltelefonnetz (40) zu ermöglichen.

12. System gemäß einem der Ansprüche 9 bis 11, bei dem das gesicherte Element am Endgerät angelötet ist.

13. System gemäß einem der Ansprüche 9 bis 12 in Abhängigkeit von einem der Ansprüche 1 bis 3, bei dem der durchgeführte Test ein Test eines Bauelements des Endgeräts ist.

14. System gemäß einem der Ansprüche 1 bis 13, bei dem der Server (60) dazu ausgelegt ist, Ergebnisse eines zuvor durch das Testprogramm durchgeführten Tests zu empfangen (E18; E36) und die Testvorschriften in Abhängigkeit von den Ergebnissen zu bestimmen (E20; E206; E222).

15. System gemäß Anspruch 14, bei dem die Testvorschriften in einer Datenbank des Servers (60) gespeichert sind.

16. Verfahren, das durch wenigstens ein in einem Speicher (14) eines einen Prozessor (12) und eine Eingangs-/Ausgangsschnittstelle (18) aufweisenden gesicherten Elements (10) gespeichertes Programm durchgeführt wird, wobei das wenigstens eine Programm Anweisungen enthält, die das System gemäß einem der Ansprüche 1 bis 15 dazu führt, die folgenden Schritte auszuführen;
- Sammeln (E14) von Informationen über den Aufbau oder die Umgebung des gesicherten Elements (10),
- Empfangen (E18) der gesammelten Informationen durch einen Server, um Testvorschriften in Abhängigkeit von den gesammelten Informationen zu bestimmen und um die bestimmten Testvorschriften an das gesicherte Element zu schicken,
- Durchgehen (E30; E104; E214; E324) wenigstens einer über die Eingangs-/Ausgangsschnittstelle (18) erhaltenen Testvorschrift,
- Durchführen (E32; E106; E216; E326) wenigstens eines Tests gemäß der durchgegangenen Testvorschrift.

## Claims

1. System comprising a server and a secure element (10) comprising a processor (12), an input/output interface (18) and at least one memory (14), wherein a program for detecting information (INFO) stored in the memory (14) is designed to collect information about the configuration or the environment of the secure element (10), the server being designed to receive the information collected,
**characterised in that** the server is designed to determine test directives depending on the information collected and to transmit the determined test directives to the secure element, and **in that** a test program (TEST) stored in the memory (14) is designed to browse (E30; E104; E214; E324) at least one test directive received through the input/output interface (18) and to carry out (E32; E106; E216; E326) at least one test according to the browsed test directive.

2. System according to claim 1, designed to receive a test launch instruction (E26; E100; E226; E320) coming from a server (60).

3. System according to claim 1 or 2, wherein the directive received is stored in a file and wherein the test program (TEST) is designed to browse the test directive by reading in the file.

4. System according to one of claims 1 to 3, wherein the test carried out is a test of an application (APP) stored in said memory (14).

5. System according to claim 4, wherein the test program (TEST) is designed to carry out the test by sending data to the application (APP).

6. System according to one of claims 1 to 4, wherein the test program (TEST) is designed to carry out the test by sending at least one command to an operating system (OS) of the secure element (10).

7. System according to one of claims 1 to 4, wherein the test program (TEST) is designed to carry out the test by emulating at least one command received from a terminal (20) via the input/output interface (18).

8. System according to one of claims 1 to 7, wherein the secure element is a microcircuit card.

9. System according to one of claims 1 to 8, comprising a terminal (20) equipped with the secure element (10), and comprising at least one communication module (24; 26) designed to allow an exchange of data with the server (60).

10. System according to claim 9, wherein the communication module (26) is designed to allow an exchange of data with the server (60) via a local wireless network.

11. System according to claim 9, wherein the communication module (24) is designed to allow an exchange of data with the server (60) via a mobile telephony network (40).

12. System according to one of claims 9 to 11, wherein the secure element is welded to the terminal.

13. System according to one of claims 9 to 12, taken dependent upon one of claims 1 to 3, and wherein the test carried out is a test of a component of the terminal.

14. System according to one of claims 1 to 13, wherein the server (60) is designed to receive (E18; E36) results from a test carried out beforehand by the test program, and to determine (E20; E206; E222) the test directives depending on said results.

15. System according to one of claims 14 to 16, wherein the test directives are stored in a database of the server (60).

16. Method implemented of at least one program stored in a memory (14) of a secure element (10) comprising a processor (12) and an input/output interface (18), the at least one program comprising instructions which lead the system according to one of claims 1-15 to execute the following steps:
- collecting (E14) information on the configuration or the environment of the secure element (10);
- receiving (E18) the collected information by a server, to determine test directives depending on the collected information and to transmit the determined test directives to the secure element;
- browsing (E30; E104; E214; E324) at least one test directive received through the input/output interface (18);
- implementing (E32; E106; E216; E326) at least one test according to the browsed test directive.
